**Europäisches Patentamt**

**European Patent Office**

**Office européen des brevets**

(19)

(11) **EP 1 134 902 A1**

(12) **DEMANDE DE BREVET EUROPEEN**

(43) Date de publication:
**19.09.2001 Bulletin 2001/38**

(51) Int Cl.7: **H03M 13/29**, H03M 13/35,
H04L 1/00, H03M 13/00

(21) Numéro de dépôt: **01400661.3**

(22) Date de dépôt: **13.03.2001**

(84) Etats contractants désignés:
**AT BE CH CY DE DK ES FI FR GB GR IE IT LI LU
MC NL PT SE TR**
Etats d'extension désignés:
**AL LT LV MK RO SI**

(30) Priorité: **13.03.2000 FR 0003339**

(71) Demandeur: **Mitsubishi Electric Information
Technology Centre Europe B.V.
1101 AG Amsterdam Zuidoost (NL)**

(72) Inventeurs:
• **Gueguen, Arnaud**
 **35700 Rennes (FR)**
• **Mottier, David**
 **35700 Rennes (FR)**

(74) Mandataire: **Maillet, Alain
Cabinet le Guen & Maillet,
5, Place Newquay,
B.P. 70250
35802 Dinard Cedex (FR)**

(54) **Turbo codage/décodage adaptatif**

(57) Un procédé de transmission numérique de type
à codage correcteur d'erreurs comprend une procédure
de codage (30) pour générer, à partir d'une information
utile, une information codée avec une certaine redondance globale caractérisée par un rendement global. La
procédure de codage comprend au moins deux étapes
de codage élémentaire associées à des étapes de poinçonnage respectives et concaténées en série, une étape d'entrelacement intervenant entre deux étapes de
codage élémentaire successives. Chaque étape de codage élémentaire génère, à partir d'une information en
entrée, une information en sortie avec une certaine redondance d'étape de codage élémentaire caractérisée
par un rendement d'étape de codage élémentaire modifié par le poinçonnage correspondant, ledit rendement
global étant égal au produit des rendements desdites
étapes de codage élémentaires modifiés chacun par le
poinçonnage correspondant. Selon l'invention, le procédé comprend en outre une étape d'observation des conditions de transmission pour déterminer au moins un paramètre caractéristique des conditions de transmission,
une étape de sélection de répartition de redondance
(33 ; 43) pour sélectionner en fonction dudit au moins
un paramètre une distribution desdites redondances
d'étapes de codage élémentaire parmi une pluralité de
distributions desdites redondances d'étapes de codage
élémentaire pour lesquelles ledit rendement global est
le même, et une étape d'adaptation de procédure de codage (33) pour adapter ladite procédure de codage en
fonction de ladite répartition de redondance sélectionnée.

FIG. 2

## Description

La présente invention concerne de manière générale un procédé de transmission numérique de type à codage correcteur d'erreurs, notamment pour un système de transmission numérique sur canal à perturbation importante. Plus précisément, elle concerne une amélioration d'un procédé de transmission numérique, de type à codage correcteur d'erreurs utilisant notamment des schémas de codage de type turbo-codes à concaténation série, permettant une adaptation aux conditions de transmission.

Un système de transmission numérique véhicule de l'information en utilisant un support physique comme le câble, la fibre optique ou la propagation sur un canal radioélectrique satellitaire ou non. On désignera un tel support physique par le terme canal. Généralement, un tel système comprend notamment, au niveau de l'émission, un dispositif codeur de canal et, au niveau de la réception, un dispositif décodeur.

Le dispositif codeur de canal a une fonction dite de codage correcteur d'erreurs. La fonction de codage correcteur d'erreurs consiste à générer, pour une information utile, une information redondante, qui, lors du décodage au niveau de la destination, va permettre de reconstituer l'information utile à partir de l'information arrivant à destination entachée par les perturbations intervenant sur le canal, notamment de type bruit, atténuations et interférences. Un procédé de transmission numérique utilisant un tel codage canal associé à un décodage correspondant de destination est appelé procédé de transmission de type à codage correcteur d'erreurs.

La qualité d'un système de transmission numérique est évaluée, en général, en calculant la probabilité d'erreur par bit transmis. Cette dernière est notamment fonction du rapport signal sur bruit de la liaison. Le codage correcteur d'erreurs, associé au décodage correspondant, vise à améliorer la qualité de la transmission grâce à la redondance introduite dans le signal. Des informations redondantes ayant été introduites par le dispositif codeur, le dispositif décodeur va utiliser les informations redondantes reçues et sa connaissance de la loi de codage pour corriger les erreurs éventuelles. Autrement dit, au niveau de la destination, à partir de l'information reçue endommagée par le canal, est reconstituée l'information utile correspondante. Par exemple, du fait de la redondance, seules certaines séquences d'information codée, conformes à la loi de codage, sont possibles. Si des séquences d'information reçue à décoder sont différentes de ces séquences possibles, c'est qu'elles correspondent à de l'information détériorée par le canal. Dans le cas d'un décodage à maximum de vraisemblance, le procédé de décodage va reconstituer l'information utile en déterminant, à partir de la séquence d'information reçue et en considérant les différentes séquences permises, la séquence d'information utile la plus vraisemblable.

Plus la capacité de discrimination entre les séquences que permet l'ensemble des opérations de codage et décodage est importante, plus la capacité de correction d'erreurs est importante.

Une conséquence importante de la redondance introduite par le codage est l'accroissement du débit numérique. Un paramètre important du codeur est donc son rendement qui est égal au nombre de bits d'information par bit transmis. En général plus le rendement est faible, plus le code est robuste.

La performance d'une transmission à codage correcteur d'erreurs se mesure généralement en terme de taux d'erreurs binaires ou paquets pour un rapport $E_b/N_o$ donné, où $E_b$ est l'énergie par bit d'information et $N_o$ est la densité spectrale de puissance du bruit. On qualifie de plus ou moins performant un code selon que son emploi permet un taux d'erreurs plus ou moins faible pour un rapport $E_b/N_o$ donné et pour une complexité de décodage donnée.

Il est possible d'améliorer la performance en utilisant un code de plus faible rendement. Cependant, cela se fait au détriment de l'efficacité spectrale de la transmission. Généralement, le rendement utilisé est le rendement permettant de garantir un taux d'erreurs prédéterminé, ce rendement pouvant éventuellement évoluer suivant les conditions de transmission.

Des codes correcteurs d'erreurs connus sont les codes en bloc. Le codage en bloc consiste à associer à chaque bloc de k bits d'information un bloc de n bits (n>k) contenant donc (n-k) bits de redondance. Le bloc de n bits est obtenu en multipliant le bloc de k bits utiles par une matrice à k lignes et n colonnes appelée matrice génératrice du code. Lorsque, par permutation, la matrice génératrice est écrite sous une forme telle qu'elle fait apparaître la matrice identité, de sorte que, dans le bloc de n bits, les k bits d'information et les n-k bits de redondance sont séparés, le code est dit systématique. Le rendement du code est égal à k/n. Le dispositif décodeur détecte les erreurs et les corrige par l'intermédiaire de la distance de Hamming minimale. De tels codes détecteurs d'erreurs bien connus dans la technique sont par exemple les codes de Hamming, les codes BCH et les codes de Reed-Solomon.

Est également bien connu le fait d'effectuer un codage correcteur d'erreurs à l'aide d'un ou plusieurs codeurs convolutifs. Leur principe de fonctionnement consiste à coder un bloc de k éléments binaires présents à l'entrée du codeur en un bloc de n éléments binaires en tenant compte également de m blocs précédents le bloc présent en entrée, à l'aide d'un dispositif à registre. La sortie du codeur convolutif est constituée de n éléments binaires codés générés par le produit de convolution des k éléments binaires présents à l'entrée avec la réponse du codeur définie par n polynômes générateurs. Le nombre n de polynômes générateurs du codeur est appelé dimension du codeur. Le rendement du code est égal à k/n. Le dispositif décodeur reconstruit les données d'origine par exemple à l'aide d'un décodage de type séquentiel, un décodage suivant le symbole le plus vraisemblable, ou un décodage suivant la sé-

# EP 1 134 902 A1

quence la plus vraisemblable, ainsi que décrit, par exemple, dans le document « Digital Communications », par J.G. Proakis, paru en 1995 aux éditions MacGraw-Hill. Par exemple, l'algorithme de Viterbi assure un décodage optimal suivant la séquence la plus vraisemblable.

Selon une variante de ce type de codes, le codage ne se fait pas en prenant directement en compte une série de m informations utiles précédant l'information à coder, mais en utilisant une série de m informations auxiliaires, mémorisées dans un dispositif de type registre à décalage obtenues chacune par combinaison mathématique d'une information utile et de m informations auxiliaires calculées précédemment. Un tel code convolutif est dit récursif. Lorsque, en outre, l'information utile ressort telle quelle parmi les n sorties du codeur au côté de (n-1) informations codées ou informations redondantes, le code résultant est appelé code convolutif récursif systématique, ou code RSC.

Est également connu le fait d'associer différents codeurs afin d'augmenter la performance du codage. Par exemple, les données codées par un premier codeur peuvent alimenter un second codeur. Le décodage se fait symétriquement, en commençant par le second code.

Un type performant d'association de codeurs a été proposé, ainsi que décrit notamment dans le document « Near Shannon Limit Error — Correcting Coding and Decoding : Turbo-codes », par C. Berrou, A. Glavieux, P. Thitimajshima, paru dans ICC-1993, Conference Proceedings aux pages 1064-1070. Ce type d'association de codeurs a donné naissance a une famille de schémas de codage connue dans la technique sous le nom de turbo-codes. L'on désignera par turbo-codes les codes correcteurs d'erreurs basés sur l'association, appelée concaténation, de plusieurs codes simples, appelés codes élémentaires, avec intervention d'opérations de permutation, appelées entrelacements qui modifient l'ordre de prise en compte des données par chacun des codes simples. Par codes élémentaires, on entend des codes introduisant une redondance, du type décrit plus haut. Il peut s'agir, par exemple, de codes convolutifs récursifs systématiques pour les turbo-codes convolutifs, des codes en bloc de Hamming ou BCH pour les turbo-codes en bloc. Différents types de concaténation peuvent être envisagés. Dans la concaténation parallèle, la même information est codée par chaque codeur séparément après avoir été entrelacée. Dans la concaténation série, la sortie de chaque codeur est codée par le codeur suivant après avoir été entrelacée. On appelle dimension du turbo-code le nombre de codeurs élémentaires utilisés pour mettre en oeuvre ce turbo-code. Un schéma de turbo-codage bien connu consiste en une concaténation parallèle de codes élémentaires de type Code Convolutif Récursif Systématique (RSC). On désigne ce turbo-code par le terme PCCC. Des exemples de turbo-codes à concaténation série sont les SCCC qui utilisent des codes élémentaires de type codes convolutifs et les turbo-codes en bloc qui utilisent des codes élémentaires de type codes en bloc. Des turbo-codes à concaténation série sont décrits notamment dans les articles « Serial concatenation of interleaved codes : Performance analysis, design and iteratives decoding » écrit par S. Benedetto, G Montorsi, D. Divsalar et F. Pollara, dans JPL TDA Prog. Rep., vol. 42-126, en août 1996 et « Analysis Design and Iterative Decoding of Double Serially Concatenated Codes with interleavers » écrit par S. Benedetto, D. Divsalar, G. Montorsi et F. Pollara, dans IEEE JOURNAL ON SELECTED AREAS IN COMMUMCATIONS, vol 16, No 2, pages 231-244 en février 1998.

Une information codée par un turbo-code peut être décodée par un procédé itératif appelé par la suite turbo-décodage. Pour effectuer ce turbo-décodage, sont associés plusieurs décodeurs élémentaires à entrées et sorties pondérées correspondant chacun à un codeur élémentaire du dispositif de codage. Les entrées et sorties pondérées se font en termes de probabilités, de rapports de vraisemblance, ou de logarithmes de rapports de vraisemblance. Des entrelaceurs et désentrelaceurs permettent à chaque décodeur de prendre en compte une information qui se présente dans le même ordre qu'une information correspondante en sortie ou en entrée du codeur correspondant. Chaque décodeur élémentaire reçoit une information correspondant à une information de sortie du codeur correspondant et une information correspondant à une information d'entrée du codeur correspondant et génère une information de fiabilité accrue. L'information supplémentaire générée par un décodeur élémentaire est appelée information extrinsèque. Elle est utilisée par un ou plusieurs autres décodeurs élémentaires après entrelacement ou désentrelacement adapté. L'échange d'information extrinsèque se fait entre décodeurs élémentaires au sein d'une même étape, et de cette étape vers l'étape suivante. Chaque nouvelle étape accroît donc la fiabilité de l'information générée en sortie. Les décodeurs élémentaires utilisent par exemple les algorithmes MAP, LogMAP, MaxLogMAP, SOVA, Chase, qui sont décrits, par exemple, dans les articles « Optimal and sub-optimal maximum a posteriori algorithms suitable for turbo decoding » de P. Robertson, P. Hoeher, E. Villebrun, paru dans European Trans. on Telecommun., vol. 8, mars-avril 1997, aux pages 119-125 et « A very low complexity block turbo decoder for product codes » de R. Pyndiah, P. Combelles, P. Adde, paru dans Proc. IEEE Globecom 1996, aux pages 101-105. Un seuillage est appliqué sur l'information en sortie de la dernière étape de décodage pour générer l'information décodée.

L'appellation turbo-décodage englobe divers schémas de concaténation envisageables, dépendant par exemple du type de turbo-codage mis en oeuvre. Par exemple, dans un turbo-décodage correspondant à un turbo-code à concaténation série, les décodeurs élémentaires étant associés dans l'ordre inverse des codeurs élémentaires, chaque décodeur élémentaire reçoit deux informations pondérées a priori correspondant l'une à l'information de sortie du codeur élémentaire correspondant et l'autre à l'information d'entrée du codeur élémentaire correspondant. Ce décodeur élémentaire produit deux informations pondérées a posteriori, l'une correspondant à la sortie du codeur élémentaire correspondant, et qui devient donc, lors d'une itération suivante, après entrelacement correspondant, entrée a priori d'un décodeur élémentaire précédent, et l'autre correspondant à l'entrée du codeur élémentaire correspondant, et qui devient donc, dans la même itération, après désentrelacement correspondant, entrée a priori d'un décodeur élémentaire suivant. Des exemples de turbo-décodage pour des turbo-codes à concaténation série sont décrits notamment dans les articles précités « Serial concatenation of interleaved codes : Performance analysis, design and iteratives decoding » écrit par S. Benedetto, G Montorsi, D. Divsalar et F. Pollara, dans JPL TDA Prog. Rep., vol. 42-126, en août 1996 et « Analysis Design and Iterative Decoding of Double Serially Concatenated Codes with interleavers » écrit par S. Benedetto, D. Divsalar, G. Montorsi et F. Pollara, dans IEEE JOURNAL ON SELECTED AREAS IN COMMUNICATIONS, vol 16, No 2, pages 231-244 en février 1998. Les décodeurs élémentaires sont en général concaténés en série mais d'autres types de concaténations peuvent éventuellement être envisagés.

Quoiqu'il en soit, l'on peut toujours définir l'information extrinsèque comme le supplément d'information apporté par un décodage élémentaire associé à un codage élémentaire par rapport à une information a priori, intervenant en entrée du décodage élémentaire.

Est également connu le fait que le rendement d'un code peut être augmenté par une opération de poinçonnage qui consiste à ne pas transmettre certains bits d'une séquence d'information, ainsi qu'il est décrit, par exemple, dans l'article « Rate-Compatible Punctured Convolutional (RCPC) codes and their application», par J. Hagenauer, paru dans IEEE Trans., Vol COM-36.4, 1988, aux pages 389-400 ou dans l'article «New Rate Compatible Punctured Convolutional Codes for Viterbi decoding », par L.H.C. Lee, paru dans IEEE Trans., Vol. COM-42.2, 1994, aux pages 3073-3079. Ces bits non transmis sont en général des bits d'information redondante. Une ou plusieurs opérations de poinçonnage interviennent au niveau de l'émission, après une ou plusieurs opérations de codage. Au niveau de la destination, une ou plusieurs opérations réciproques de dépoinçonnage sont effectuées avant une ou plusieurs opérations de décodage. Le poinçonnage de bits d'information redondante diminue la capacité de correction d'un code et augmente son rendement.

Dans le cas des turbo-codes à concaténation série, le poinçonnage, au niveau de l'émission, peut intervenir après chaque opération de codage élémentaire, avant l'opération d'entrelacement. Il y aura généralement, dans le cas des turbo-codes à concaténation série, autant de matrices de poinçonnage qu'il y a de codeurs élémentaires. Le rendement des codes élémentaires n'étant généralement pas le même et le poinçonnage étant réparti généralement inégalement, la taille d'un entrelaceur donné va dépendre d'une part du rendement du code élémentaire qui le précède et d'autre part de la matrice de poinçonnage intercalée entre ce code élémentaire et cet entrelaceur. Le rendement global du turbo-code série sera égal au produit des rendements des codes élémentaires modifiés chacun par le poinçonnage correspondant.

Les codes correcteurs d'erreurs de la famille des turbo-codes selon l'état de la technique décrit plus haut permettent d'obtenir une correction d'erreurs très performante tout en conservant des rendements suffisamment importants et en permettant des opérations de décodage à faible complexité au regard de la complexité du code.

Cependant, l'on sait que les performances d'une transmission utilisant un code correcteur d'erreurs varient selon les conditions de transmission. On entend par conditions de transmission les paramètres influant sur les performances de la transmission comme notamment le rapport signal sur bruit, mais également le taux d'erreurs binaires ou paquets, le rapport signal sur interférence plus bruit, le nombre d'utilisateurs actifs d'un système de télécommunications, la qualité de service requise par le système de transmission, la vitesse de déplacement de l'utilisateur du système de transmission ou tout autre paramètre.

Dans l'état de la technique, l'adaptation aux conditions de transmission se fait en diminuant ou augmentant le rendement afin de rendre le code plus ou moins robuste suivant que le canal est plus ou moins sévère.

Un objet de la présente invention est de permettre une adaptation dynamique aux conditions de transmission d'un procédé de transmission à code correcteur d'erreurs de type turbo-code à concaténation série, ce à rendement constant.

A cet effet, elle propose un procédé de transmission numérique de type à codage correcteur d'erreurs, comprenant, d'une part, avant une étape de transmission sur un canal, une procédure de codage pour générer, à partir d'une information utile, une information codée avec une certaine redondance globale caractérisée par un rendement global, ladite procédure de codage comprenant au moins deux étapes de codage élémentaire associées à des étapes de poinçonnage respectives et concaténées en série, une étape d'entrelacement intervenant entre deux étapes de codage élémentaire successives, chacune desdites étapes de codage élémentaire générant, à partir d'une information en entrée, une information en sortie avec une certaine redondance d'étape de codage élémentaire caractérisée par un rendement d'étape de codage élémentaire modifié par le poinçonnage correspondant, ledit rendement global étant égal au produit des rendements desdites étapes de codage élémentaires modifiés chacun par le poinçonnage correspondant, et d'autre part, après ladite étape de transmission sur ledit canal, une procédure de décodage pour obtenir, à partir d'une information à décoder, une estimation de ladite information utile en corrigeant des erreurs de transmission, ladite procédure de décodage étant itérative et chacune de ses itérations comprenant des étapes de décodage élémentaire correspondant auxdites étapes de codage élémentaire ainsi que des étapes de désentrelacement et de dépoinçonnage et des étapes de poinçonnage et d'entrelacement permettant à chaque étape de décodage élémentaire de prendre en compte des informations correspondant aux informations respectivement en sortie et en entrée du codeur correspondant, ledit procédé de transmission étant caractérisé en ce qu'il comprend en outre une étape d'observation des conditions de transmission pour déterminer au moins un paramètre caractéristique des conditions de transmission, une étape de sélection de répartition de redondance pour sélectionner en fonction dudit au moins un paramètre une distribution desdites redondances d'étapes de codage élémentaire parmi une pluralité de distributions desdites redondances d'étapes de codage élémentaire pour lesquelles ledit rendement global est le même, et une étape d'adaptation de procédures de codage et de décodage pour adapter ladite procédure de codage et ladite procédure de décodage en fonction de ladite répartition de redondance sélectionnée.

Ainsi, en fixant un rendement cible $R_c$ supérieur au rendement minimum $R_m$ de la procédure de codage, la répartition de la redondance est ajustée dynamiquement au cours du temps suivant les conditions de transmission afin de garantir les meilleures performances. Ainsi qu'il a été dit précédemment, le ou les paramètres caractéristiques des conditions de transmission peuvent être le taux d'erreurs binaires, le taux d'erreurs paquets, le rapport signal/bruit, le rapport signal sur interférence plus bruit, le nombre d'utilisateurs actifs d'un système de télécommunication, la qualité de service requise par le système de transmission, la vitesse de déplacement de l'utilisateur du système de transmission ou tout autre paramètre susceptible d'influer sur les performances du système de transmission. Ce ou ces paramètres peuvent être directement évalués au niveau de l'émission, par exemple, à partir de mesures faites sur les signaux transmis. Ils peuvent aussi être fournis par un signal de contrôle externe. La pluralité de répartitions de redondance pour chaque rendement global $R_C$ est prédéterminée en fonction d'une étude préalable des performances du codage en fonction des conditions de transmission permettant de déterminer, pour chaque condition de transmission, la répartition de redondance conduisant aux meilleures performances. Les schémas de poinçonnage correspondant aux différentes conditions de transmission peuvent être mémorisés dans une table de correspondance.

Selon un autre aspect de la présente invention, ladite étape d'adaptation de procédures de codage et de décodage modifie lesdites étapes de poinçonnage et d'entrelacement de ladite procédure de codage ainsi que lesdites étapes de désentrelacement et de dépoinçonnage et lesdites étapes de poinçonnage et d'entrelacement de ladite procédure de décodage en fonction de ladite répartition de redondance sélectionnée.

Selon un autre aspect de la présente invention, ladite étape d'adaptation de procédures de codage et de décodage supprime une ou plusieurs étapes de codage élémentaire et les étapes de poinçonnage et d'entrelacement correspondantes de ladite procédure de codage, ainsi que les étapes de décodage élémentaire, les étapes de désentrelacement et de dépoinçonnage et les étapes de poinçonnage et d'entrelacement correspondantes de ladite procédure de décodage en fonction de ladite répartition de redondance sélectionnée.

Bien entendu, l'étape d'adaptation de procédures de codage et de décodage peut combiner les deux modes de fonctionnement qui viennent d'être décrits.

Les étapes de codage élémentaires pourront aussi bien utiliser des codes convolutifs que des codes en bloc.

Selon un aspect de la présente invention, ladite étape d'observation des conditions de transmission et ladite étape de sélection de redondance sont exécutées au niveau d'un émetteur pour lequel est exécutée ladite procédure de codage, ladite répartition de redondance sélectionnée étant transmise à un récepteur pour lequel est exécutée ladite procédure de décodage.

Alternativement, ladite étape d'observation des conditions de transmission et ladite étape de sélection de redondance sont exécutées tant au niveau d'un émetteur pour lequel est exécutée ladite procédure de codage qu'au niveau d'un récepteur pour lequel est exécutée ladite procédure de décodage.

Bien entendu, il est impératif que la détermination d'une répartition de redondance soit la même au niveau de l'émetteur que du récepteur. Aussi, cette dernière variante ne sera employée que lorsque le ou les paramètres caractéristiques des conditions de transmission ne varient pas selon que l'on se place au niveau de l'émetteur ou que l'on se place au niveau du récepteur. Bien entendu les algorithmes et/ou tables de référence utilisés pour déterminer ladite répartition de redondance seront identiques au niveau de l'émetteur et du récepteur.

Les caractéristiques de l'invention mentionnées ci-dessus, ainsi que d'autres, apparaîtront plus clairement à la lecture de la description suivante d'un exemple de réalisation, ladite description étant faite en relation avec les dessins joints, parmi lesquels :

la Fig. 1 est un schéma illustrant le principe de base d'un mode de réalisation d'une procédure de codage d'un procédé de transmission selon la présente invention ;
la Fig. 2 est un schéma illustrant la sélection dynamique de la redondance exécutée dans la procédure de codage de la Fig. 1 ;
la Fig. 3 est un schéma illustrant le principe de base d'un mode de réalisation d'une procédure de décodage d'un procédé de transmission selon la présente invention ;
la Fig. 4 est un schéma illustrant la sélection dynamique du schéma de turbo-décodage exécutée dans la procédure de décodage de la Fig. 3 ;

la Fig. 5 est un schéma illustrant un turbo-codeur pour turbo-code série à n dimensions ; et
la Fig. 6 est un schéma illustrant un turbo-décodeur pour turbo-code série à 3 dimensions.

Globalement, dans un procédé de transmission numérique de type à codage correcteur d'erreurs, la présente invention permet, en maintenant constant un rendement global, c'est-à-dire un rendement égal au produit des rendements d'étapes de codage élémentaires modifiés respectivement par des étapes de poinçonnage, égal à un rendement cible $R_c$ prédéterminé supérieur au rendement minimum $R_m$ du code correcteur d'erreurs, de sélectionner en fonction des conditions de transmission une distribution des redondances des étapes de codage élémentaire parmi une pluralité de distributions de redondances pour lesquelles le rendement global est égal au rendement cible $R_c$, de telle sorte que les performances du procédé de transmission numérique à codage correcteur d'erreurs soient optimales pour ces conditions de transmission. Les modifications apportées au niveau de la procédure de codage sont répercutées de manière correspondante au niveau de la procédure de décodage.

Les modes de réalisation de la présente invention décrits s'appliquent à un procédé de transmission de type à codage correcteur d'erreurs dans lequel, au niveau de l'émission, une procédure de codage comprend n étapes de codage élémentaire associées à des étapes de poinçonnage respectives et concaténées en série, une étape d'entrelacement intervenant entre deux étapes de codage élémentaire successives. Il peut s'agir notamment d'un procédé de transmission utilisant un code correcteur d'erreurs de type turbo-code à concaténation série. La procédure de codage génère, à partir d'une information utile, une information codée avec une certaine redondance globale caractérisée par un rendement global. Chacune des étapes de codage élémentaire génère, à partir d'une information en entrée, une information en sortie avec une certaine redondance d'étape de codage élémentaire caractérisée par un rendement d'étape de codage élémentaire modifié par le poinçonnage correspondant. Le rendement global est égal au produit des rendements des étapes de codage élémentaires modifiés chacun par le poinçonnage correspondant.

Au niveau de la destination, une procédure de décodage reconstitue l'information à l'aide de n étapes de décodage élémentaire correspondant aux n étapes de codage élémentaire. La procédure de décodage est itérative et chacune de ses itérations comprend n étapes de décodage élémentaire correspondant aux n étapes de codage élémentaire ainsi que des étapes de désentrelacement et de dépoinçonnage et des étapes de poinçonnage et d'entrelacement permettant à chaque étape de décodage élémentaire de prendre en compte des informations correspondant aux informations respectivement en sortie et en entrée du codeur correspondant.

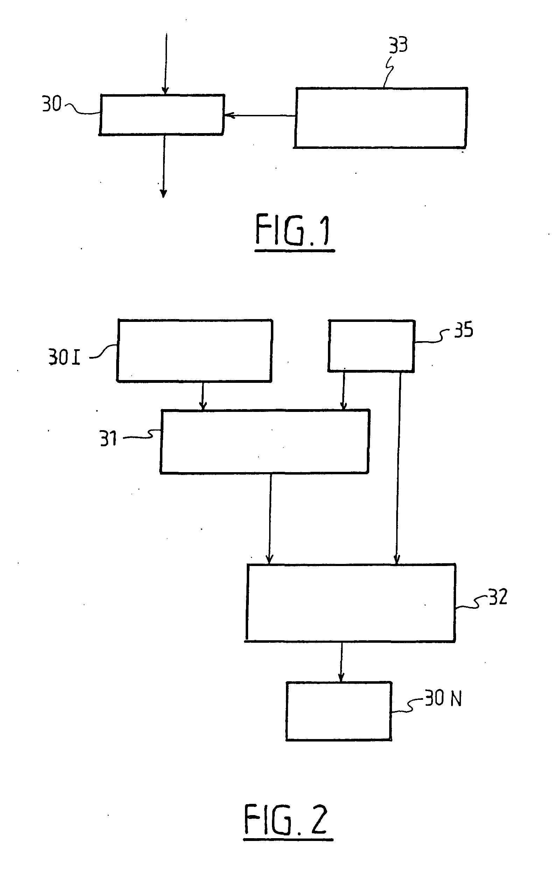

La Fig. 1 présente sous forme schématique le principe de base d'un mode de réalisation d'une procédure de codage d'un procédé de transmission selon la présente invention.

Une procédure de codage 30 effectue le codage de séquences d'information utile à l'aide d'un turbo-code série. A l'origine, ainsi qu'on le voit sur la Fig. 2, il s'agit d'une procédure de codage $30_I$ à turbo-code série de dimension initiale n et de rendement initial $R_m$. Un rendement cible $R_c$ supérieur à $R_m$ est fixé. Pour ce rendement cible, la redondance peut être répartie de différentes façons entre les étapes de codage élémentaires telles que modifiées par les étapes de poinçonnage. Par exemple, si les séquences d'information à coder sont des séquences de bits, l'on a :

$$\prod_{i=1}^{n} R_i = \prod_{i=1}^{n} \frac{N_{in,i}}{N_{out,i}} = R_c \qquad (1)$$

où $N_{in,i}$ est le nombre de bits en entrée de la $i^{\text{ème}}$ étape de codage élémentaire, $N_{out,i}$ est le nombre de bits en sortie de l'étape de poinçonnage suivant cette $i_{\text{ème}}$ étape de codage élémentaire, et $R_i$ est le rendement de la $i^{\text{ème}}$ étape de codage élémentaire tel que modifié par le poinçonnage correspondant.

Pour un même rendement cible $R_c$, on peut donc envisager une pluralité de répartitions de la redondance parmi les étapes de codage élémentaire associées aux étapes de poinçonnage.

Selon l'invention, le choix d'une répartition de redondance donnée se fait dynamiquement en fonction des conditions de transmission.

Parallèlement à la procédure de codage, un traitement d'observation des conditions de transmission et de sélection dynamique de la redondance 33 (voir la Fig. 1) analyse, dans une première étape 35 (voir la Fig. 2), les conditions de transmission. Ce traitement mesure les conditions de transmission au moyen d'un ou plusieurs paramètres. Par exemple, ce traitement peut calculer le rapport signal sur bruit. L'analyse de conditions de transmission peut se faire en permanence ou uniquement à certains moments donnés. Elle peut être réalisée à chaque fois qu'une séquence doit être codée, ou bien encore pour un groupe de séquences à coder ou encore pour certaines séquences particulières.

Le ou les paramètres calculés par le traitement 35 d'observation des conditions de transmission, comme le rapport signal sur bruit, permettent au traitement 33, dans une seconde étape, de sélectionner une répartition de redondance. La sélection est effectuée parmi une pluralité de distributions de redondances prédéterminées satisfaisant la relation (1) pour le rendement cible $R_c$. Ces distributions de redondances sont, par exemple, mémorisées dans une table de référence. Elles peuvent également être calculées à l'aide d'un algorithme prédéterminé. Chacune de ces distributions de redondances correspond, pour une condition de transmission donnée, à une répartition de redondance optimale, c'est-à-dire celle qui conduit, par exemple, aux meilleures performances de transmission. Ces performances sont mesurées, par exemple en terme de taux d'erreurs binaires. Une étude préalable permet d'associer une répartition optimale à chaque valeur du paramètre ou des paramètres qui caractérisent les conditions de transmission. De la sorte, pour chaque condition de transmission donnée, le traitement 33 sélectionne la répartition de redondance optimale, sans modification du rendement cible $R_c$.

La Fig. 2 décrit de manière plus précise la manière dont l'étape de sélection dynamique de la redondance modifie la procédure de codage. Ainsi qu'on l'a dit plus haut, la modification des redondances des étapes de codage élémentaire se fait généralement de deux façons qui peuvent se cumuler.

Une première façon de modifier des redondances d'étapes de codage élémentaire, représentée par l'étape 31 dans la Fig. 2 consiste à supprimer une ou plusieurs étapes de codage élémentaire, ainsi que les étapes de poinçonnage et d'entrelacement correspondantes. Le code correcteur d'erreurs appliqué par la procédure de codage est alors un turbo-code série de dimension n' inférieure à n.

Une seconde façon de modifier des redondances d'étapes de codage élémentaire, représentée par l'étape 32 dans la Fig. 2 consiste à modifier les matrices de poinçonnage des étapes de poinçonnage et de modifier, de manière correspondante, les matrices d'entrelacement des étapes d'entrelacement de la procédure de codage.

Lorsque l'on combine ces deux manières de procéder, ainsi que le montre la Fig. 2, l'on va d'abord exécuter l'étape 31. On obtient ainsi un turbo-code série de dimension n' inférieure ou égale à n et de rendement global $R'_m$ inférieur ou égal à $R_m$. L'étape 32 va ensuite sélectionner les matrices de poinçonnage et d'entrelacement en respectant la relation (1) de sorte que l'on obtient un turbo-code série de dimension n' et de rendement $R_c$ $30_M$.

Dans la mesure où l'on souhaite sélectionner la répartition de redondance la mieux adaptée pour chaque séquence à coder, l'étape d'analyse des conditions de transmission 35 va effectuer au moins une mesure des conditions de transmission avant chaque nouvelle séquence à coder, et, si elle détecte une modification des conditions de transmission, les étapes 31 et 32 seront à nouveau exécutées.

Les modifications mises en oeuvre au niveau de l'émission requièrent, au niveau de la réception, une opération de modification correspondante.

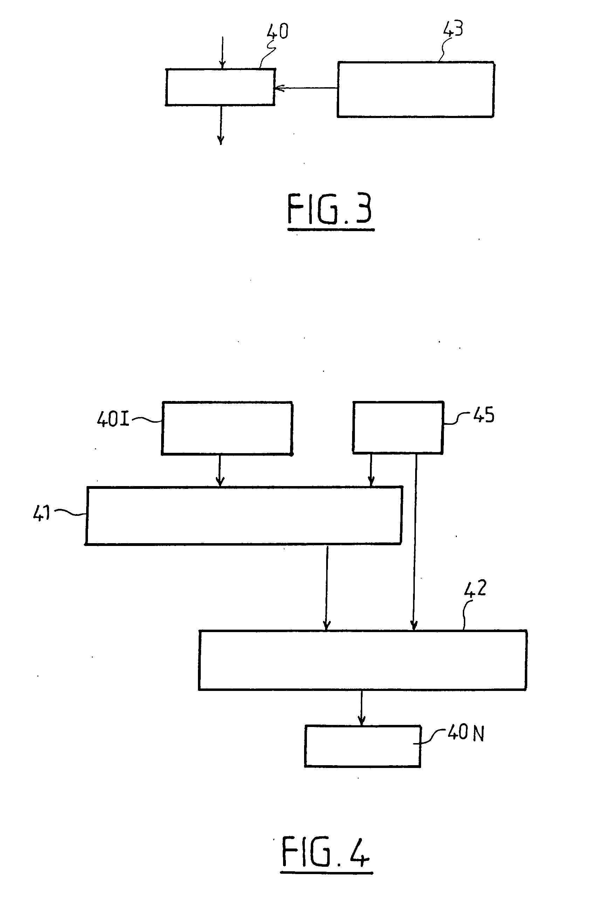

La Fig. 3 présente sous forme schématique le principe de base d'un mode de réalisation d'une procédure de décodage d'un procédé de transmission selon la présente invention.

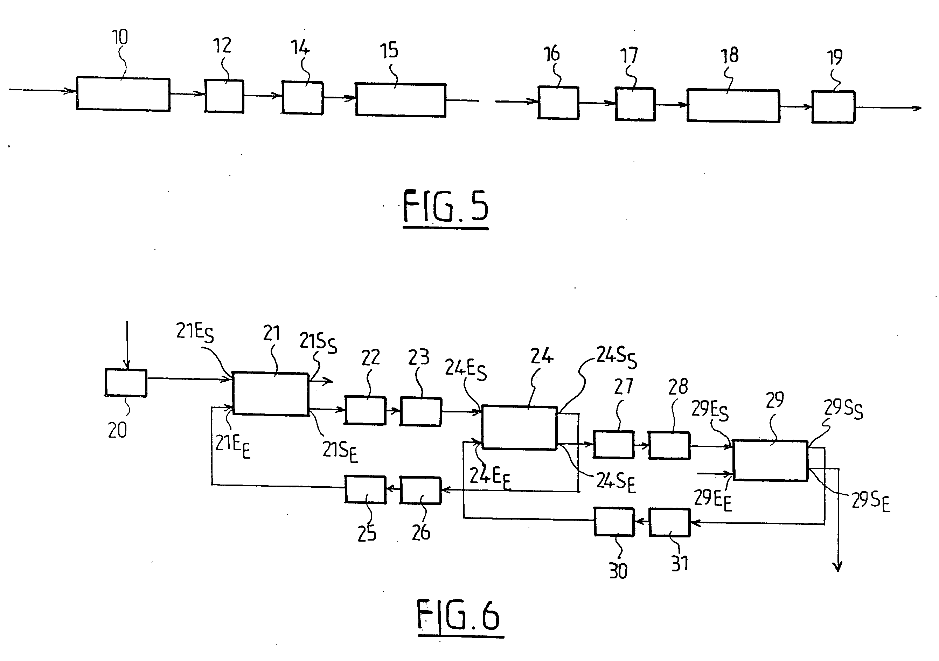

Une procédure de décodage 40 effectue le décodage de séquences d'information reçue en se basant sur le turbo-code série utilisé à l'émission. A l'origine, ainsi qu'on le voit sur la Fig. 4, il s'agit d'une procédure de décodage $40_I$ à n étapes de décodage élémentaire.

Parallèlement à la procédure de décodage, un traitement d'observation des conditions de transmission et de sélection dynamique du schéma de turbo-décodage 43 (voir la Fig. 3) analyse, dans une première étape 45 (voir la Fig. 4), les conditions de transmission. Ce traitement mesure les conditions de transmission de la même manière qu'à l'émission, de manière à pouvoir effectuer une sélection de schéma de turbo-décodage correspondant au schéma de codage retenu à l'émission. Ce traitement d'observation des conditions de transmission peut être remplacé par une information envoyée par l'émetteur qui indique directement la solution de codage retenue à l'émission. La pluralité de schémas de décodage correspondant à la pluralité de distributions de redondance de l'émission peut également être mémorisée dans une table de référence ou calculée à l'aide d'un algorithme prédéterminé.

La Fig. 4 décrit de manière plus précise la manière dont l'étape de sélection dynamique de schéma de décodage modifie la procédure de décodage.

Lorsque la procédure de codage est modifiée par l'étape 31, la procédure de décodage est modifiée par une étape 41 qui consiste à supprimer la ou les étapes de décodage élémentaire qui correspondent aux étapes de codage élémentaire supprimées par l'étape 31, ainsi que les étapes de désentrelacement et de dépoinçonnage et les étapes de poinçonnage et d'entrelacement associées.

La procédure de turbo-décodage est alors constituée de n' étapes de décodage élémentaire, correspondant aux n' étapes de codage élémentaire de la procédure de codage modifiée.

Lorsque la procédure de codage est modifiée par l'étape 32, la procédure de décodage est modifiée par une étape 42 qui consiste à modifier les étapes de désentrelacement et de dépoinçonnage et les étapes de poinçonnage et d'entrelacement en fonction des modifications appliquées aux matrices de poinçonnage et d'entrelacement correspondantes de la procédure de codage.

Lorsque l'on combine ces deux manières de procéder, ainsi que le montre la Fig. 4, l'on va d'abord exécuter l'étape 41. On obtient ainsi une procédure de turbo-décodage à n' décodeurs élémentaires, avec n' inférieur ou égal à n. L'étape 42 va ensuite modifier les étapes de désentrelacement et de dépoinçonnage et les étapes de poinçonnage et d'entrelacement de sorte que l'on obtient une procédure de turbo-décodage $40_M$ correspondant à la procédure de turbo-codage $30_M$.

Comme pour l'émission, dans la mesure où l'on souhaite sélectionner la répartition de redondance la mieux adaptée pour chaque séquence à coder, l'étape d'analyse des conditions de transmission 45, si elle est indépendante de l'étape d'analyse des conditions de transmission 35, va effectuer au moins une mesure avant chaque nouvelle séquence à décoder, et, si elle détecte une modification des conditions de transmission, les étapes 41 et 42 seront à nouveau exécutées, en se basant sur les nouvelles conditions de transmission.

La Fig. 5 présente un codeur de type turbo-codeur série de dimension n auquel peut s'appliquer la présente invention.

Le turbo-codeur série est constitué par la concaténation en série de n codeurs élémentaires à codes convolutifs ou à codes en blocs. Sur la Fig. 5, sont représentés le premier, le second et le dernier codeurs élémentaires, respectivement désignés par les références 10, 15 et 18. A chaque codeur élémentaire est associé un poinçonneur intervenant après le codeur. Sur la Fig. 5, aux codeurs élémentaires 10 et 18 correspondent les poinçonneurs 12 et 19. Le poinçonneur 16 correspond à l'avant dernier codeur élémentaire, non représenté. Les codeurs élémentaires sont séparés par (n-1) entrelaceurs. Chaque entrelaceur intervient entre le poinçonneur du codeur précédent et le codeur suivant. Sur la Fig. 5, l'entrelaceur 14 sépare les codeurs 10 et 15 et l'entrelaceur 17 sépare l'avant dernier codeur, non représenté, et le codeur 18.

L'application de l'étape 31 de la présente invention se traduit par la désactivation d'un ou plusieurs codeurs élémentaires. Désactiver un codeur élémentaire signifie également désactiver le poinçonneur et l'entrelaceur qui suivent ce codeur. Sur la Fig. 5, cela revient à court-circuiter le bloc constitué par le codeur, le poinçonneur et l'entrelaceur, autrement dit à raccorder la sortie de l'entrelaceur précédant ce bloc à l'entrée du codeur suivant ce bloc. L'étape 32 modifie les matrices de poinçonnage et d'entrelacement de manière adaptée.

La Fig. 6 présente un turbo-décodeur permettant de décoder des informations issues d'un turbo-codeur série de dimension 3.

Ce turbo-décodeur comporte trois décodeurs élémentaires 21, 24 et 29 qui correspondent aux trois codeurs élémentaires du codeur. Chaque décodeur élémentaire possède deux entrées et deux sorties pondérées. Les entrées pondérées, qui reçoivent des informations a priori, sont désignées par la référence du décodeur suivie de la lettre E. Les sorties pondérées, qui produisent des informations a posteriori, sont désignées par la référence du décodeur suivie de la lettre S. L'entrée pondérée dont la référence est affectée en outre d'un indice S reçoit une information pondérée qui correspond à la sortie du codeur correspondant. L'entrée pondérée dont la référence est affectée en outre d'un indice E reçoit une information pondérée qui correspond à l'entrée du codeur correspondant. La sortie pondérée dont la référence est affectée en outre d'un indice S génère une information pondérée qui correspond à la sortie du codeur correspondant. La sortie pondérée dont la référence est affectée en outre d'un indice E génère une information pondérée qui correspond à l'entrée du codeur correspondant. Une séquence reçue, après démodulation, est transmise à un dépoinçonneur 20 correspondant au poinçonneur associé au troisième et dernier codeur élémentaire, puis à l'entrée $21E_S$ du décodeur 21 qui correspond à ce troisième codeur élémentaire. Au sein d'une même itération, l'information en sortie $21S_E$ de ce décodeur 21 est transmise par l'intermédiaire d'un désentrelaceur 22 et d'un dépoinçonneur 23 à l'entrée $24E_S$ d'un décodeur élémentaire 24, ces trois derniers éléments correspondant au second ensemble codeur élémentaire, poinçonneur et entrelaceur du turbo-codeur. Au sein d'une même itération, l'information en sortie $24S_E$ de ce décodeur 24 est transmise par l'intermédiaire d'un désentrelaceur 27 et d'un dépoinçonneur 28 à l'entrée $29E_S$ d'un décodeur élémentaire 29, ces trois derniers éléments correspondant au premier ensemble de codeur élémentaire, poinçonneur et entrelaceur du turbo-codeur. Au cours d'une itération suivante, l'information en sortie $24S_S$ du décodeur 24 est transmise par l'intermédiaire d'un poinçonneur 26 et d'un entrelaceur 25, ces trois derniers éléments correspondant au second ensemble de codeur élémentaire, poinçonneur et entrelaceur du turbo-codeur, à l'entrée $21E_E$ du décodeur 21. De même l'information en sortie $29S_S$ du décodeur 29 est transmise par l'intermédiaire d'un poinçonneur 31 et d'un entrelaceur 30, ces trois derniers éléments correspondant au premier ensemble de codeur élémentaire, poinçonneur et entrelaceur du turbo-codeur, à l'entrée $24E_E$ du décodeur 24. La décision est prise, après un certain nombre d'itérations, au niveau de la sortie $29S_E$ du décodeur 29.

L'application de l'étape 41 de la présente invention se traduit par la désactivation d'un ou plusieurs décodeurs élémentaires. Désactiver un décodeur élémentaire signifie également désactiver le désentrelaceur et le dépoinçonneur intervenant dans la même itération en amont de ce décodeur, ainsi que le poinçonneur et l'entrelaceur intervenant dans une itération suivante en aval de ce décodeur. Par exemple, si le codeur désactivé dans la procédure de codage est le second codeur, dans l'étape de décodage seront désactivés le décodeur 24, le désentrelaceur 22, le dépoinçonneur 23, le poinçonneur 26 et l'entrelaceur 25. Sur la Fig. 6, cela revient à raccorder la sortie $21S_E$ du décodeur 21 à l'entrelaceur 27, et l'entrelaceur 30 à l'entrée $21E_E$ du décodeur 21. L'étape 42 modifie de manière adaptée les matrices des désentrelaceurs, dépoinçonneurs, poinçonneurs et entrelaceurs restants.

**Revendications**

1. Procédé de transmission numérique de type à codage correcteur d'erreurs, comprenant, d'une part, avant une étape de transmission sur un canal, une procédure de codage (30) pour générer, à partir d'une information utile, une information codée avec une certaine redondance globale **caractérisée par** un rendement global, ladite procédure de codage comprenant au moins deux étapes de codage élémentaire associées à des étapes de poinçonnage respectives et concaténées en série, une étape d'entrelacement intervenant entre deux étapes de codage élémentaire successives, chacune desdites étapes de codage élémentaire générant, à partir d'une information en entrée, une information en sortie avec une certaine redondance d'étape de codage élémentaire **caractérisée par** un rendement d'étape de codage élémentaire modifié par le poinçonnage correspondant, ledit rendement global étant égal au produit des rendements desdites étapes de codage élémentaires modifiés chacun par le poinçonnage correspondant, et d'autre part après ladite étape de transmission sur ledit canal, une procédure de décodage (40) pour obtenir, à partir d'une information à décoder, une estimation de ladite information utile en corrigeant des erreurs de transmission, ladite procédure de décodage étant itérative et chacune de ses itérations comprenant des étapes de décodage élémentaire correspondant auxdites étapes de codage élémentaire ainsi que des étapes de désentrelacement et de dépoinçonnage et des étapes de poinçonnage et d'entrelacement permettant à chaque étape de décodage élémentaire de prendre en compte des informations correspondant aux informations respectivement en sortie et en entrée du codeur correspondant, ledit procédé de transmission étant **caractérisé en ce qu'**il comprend en outre une étape d'observation des conditions de transmission (35 ; 45) pour déterminer au moins un paramètre caractéristique des conditions de transmission, une étape de sélection de répartition de redondance (33 ; 43) pour sélectionner en fonction dudit au moins un paramètre une distribution desdites redondances d'étapes de codage élémentaire parmi une pluralité de distributions desdites redondances d'étapes de codage élémentaire pour lesquelles ledit rendement global est le même, et une étape d'adaptation de procédures de codage et de décodage (31, 32 ; 41, 42) pour adapter ladite procédure de codage et ladite procédure de décodage en fonction de ladite répartition de redondance sélectionnée.

2. Procédé de transmission numérique de type à codage correcteur d'erreurs selon la revendication 1, **caractérisé en ce que** ladite étape d'adaptation de procédures de codage et de décodage (31, 32 ; 41, 42) modifie lesdites étapes de poinçonnage et d'entrelacement de ladite procédure de codage ainsi que lesdites étapes de désentrelacement et de dépoinçonnage et lesdites étapes de poinçonnage et d'entrelacement de ladite procédure de décodage en fonction de ladite répartition de redondance sélectionnée.

3. Procédé de transmission numérique de type à codage correcteur d'erreurs selon la revendication 1, **caractérisé en ce que** ladite étape d'adaptation de procédures de codage et de décodage (31, 32 ; 41, 42) supprime une ou plusieurs étapes de codage élémentaire et les étapes de poinçonnage et d'entrelacement correspondantes de ladite procédure de codage, ainsi que les étapes de décodage élémentaire, les étapes de désentrelacement et de dépoinçonnage et les étapes de poinçonnage et d'entrelacement correspondantes de ladite procédure de décodage en fonction de ladite répartition de redondance sélectionnée.

4. Procédé de transmission numérique de type à codage correcteur d'erreurs selon la revendication 3, **caractérisé en ce que** ladite étape d'adaptation de procédures de codage et de décodage (31, 32 ; 41, 42) modifie en outre lesdites étapes de poinçonnage et d'entrelacement restantes de ladite procédure de codage ainsi que lesdites étapes de désentrelacement et de dépoinçonnage restantes et lesdites étapes de poinçonnage et d'entrelacement restantes de ladite procédure de décodage en fonction de ladite répartition de redondance sélectionnée.

5. Procédé de transmission numérique de type à codage correcteur d'erreurs selon l'une quelconque des revendications précédentes, **caractérisé en ce que** lesdites étapes de codage élémentaires utilisent des codes convolutifs.

6. Procédé de transmission numérique de type à codage correcteur d'erreurs selon l'une quelconque des revendications précédentes, **caractérisé en ce que** lesdites étapes de codage élémentaires utilisent des codes en blocs.

7. Procédé de transmission numérique de type à codage correcteur d'erreurs selon l'une quelconque des revendications précédentes, **caractérisé en ce qu'**un paramètre caractéristique des conditions de transmission peut être le taux d'erreurs binaires, le taux d'erreurs paquets, le rapport signal/bruit, le rapport signal sur interférence plus bruit, le nombre d'utilisateurs actifs d'un système de télécommunication, la qualité de service requise par le système de transmission, la vitesse de déplacement de l'utilisateur du système de transmission.

**8.** Procédé de transmission de type à codage correcteur d'erreurs selon l'une quelconque des revendications précédentes, **caractérisé en ce que** ladite étape d'observation des conditions de transmission (35) et ladite étape de sélection de redondance (33) sont exécutées au niveau d'un émetteur pour lequel est exécutée ladite procédure de codage (30), ladite répartition de redondance sélectionnée étant transmise à un récepteur pour lequel est exécutée ladite procédure de décodage (40).

**9.** Procédé de transmission de type à codage correcteur d'erreurs selon l'une quelconque des revendications précédentes, **caractérisé en ce que** ladite étape d'observation des conditions de transmission (35 ;45) et ladite étape de sélection de redondance (33 ;43) sont exécutées tant au niveau d'un émetteur pour lequel est exécutée ladite procédure de codage (30) qu'au niveau d'un récepteur pour lequel est exécutée ladite procédure de décodage (40).

30 ⌇

33

FIG.1

30 I

35

31 ⌇

32

30 N

FIG. 2

FIG.3

FIG.4

FIG.5

FIG.6

Office européen
des brevets

**RAPPORT DE RECHERCHE EUROPEENNE**

Numéro de la demande

EP 01 40 0661

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.7) |
|---|---|---|---|
| X | DE 197 36 653 C (SIEMENS AG) 10 décembre 1998 (1998-12-10) * colonne 5, ligne 16 - ligne 30; figure 1 * * colonne 6, ligne 37 - colonne 7, ligne 43 * * colonne 8, ligne 43 - ligne 50; figure 6 * --- | 1,5,7 | H03M13/29 H03M13/35 H04L1/00 H03M13/00 |
| A | GB 2 160 392 A (RACAL RES LTD) 18 décembre 1985 (1985-12-18) * page 1, ligne 89 - ligne 123 * * page 2, ligne 14 - ligne 34 * * page 3, ligne 102 - ligne 113 * * page 5, ligne 58 - ligne 96 * * figure 3 * --- | 1,5-9 | |
| A | WANG C: "On the performance of turbo codes" IEEE MILITARY COMMUNICATIONS CONFERENCE. PROCEEDINGS. MILCOM 98 IEEE MILITARY COMMUNICATIONS CONFERENCE. PROCEEDINGS, 18 - 21 octobre 1998, XP002154552 Boston, MA *9. Conclusion. * --- | 1-4 | |
| A | FAN MO; KWATRA S C ; JUNGHWAN KIM: "Analysis of puncturing pattern for high rate turbo codes" MILCOM 1999. IEEE MILITARY COMMUNICATIONS. CONFERENCE PROCEEDINGS , PROCEEDINGS OF CONFERENCE ON MILITARY COMMUNICATIONS (MILCOM'99), ATLANTIC CITY, NJ, USA, 31 octobre 1999 (1999-10-31) - 3 novembre 1999 (1999-11-03), XP002154553 * le document en entier * --- -/-- | 1-4 | |

**DOMAINES TECHNIQUES RECHERCHES (Int.Cl.7)**

H03M
H04L

Le présent rapport a été établi pour toutes les revendications

| Lieu de la recherche | Date d'achèvement de la recherche | Examinateur |
|---|---|---|
| BERLIN | 2 juillet 2001 | Martínez Martínez, V |

EPO FORM 1503 03.82 (P04C02)

# EP 1 134 902 A1

**Office européen des brevets**

## RAPPORT DE RECHERCHE EUROPEENNE

**Numéro de la demande**

EP 01 40 0661

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.7) |
|---|---|---|---|
| A | ACIKEL O F ET AL: "HIGH RATE TURBO CODES FOR BPSK/QPSK CHANNELS" ATLANTA, GA, JUNE 7 - 11, 1998,NEW YORK, NY: IEEE,US, vol. CONF. 5, 7 juin 1998 (1998-06-07), pages 422-427, XP000898743 ISBN: 0-7803-4789-7 * IV. Results. * | 1-4 | |
| | | | **DOMAINES TECHNIQUES RECHERCHES (Int.Cl.7)** |

Le présent rapport a été établi pour toutes les revendications

| Lieu de la recherche | Date d'achèvement de la recherche | Examinateur |
|---|---|---|
| BERLIN | 2 juillet 2001 | Martínez Martínez, V |

CATEGORIE DES DOCUMENTS CITES

X : particulièrement pertinent à lui seul
Y : particulièrement pertinent en combinaison avec un autre document de la même catégorie
A : arrière-plan technologique
O : divulgation non-écrite
P : document intercalaire

T : théorie ou principe à la base de l'invention
E : document de brevet antérieur, mais publié à la date de dépôt ou après cette date
D : cité dans la demande
L : cité pour d'autres raisons

& : membre de la même famille, document correspondant

EPO FORM 1503 03.82 (P04C02)

**ANNEXE AU RAPPORT DE RECHERCHE EUROPEENNE
RELATIF A LA DEMANDE DE BREVET EUROPEEN NO.**     EP 01 40 0661

La présente annexe indique les membres de la famille de brevets relatifs aux documents brevets cités dans le rapport de recherche européenne visé ci-dessus.
Lesdits members sont contenus au fichier informatique de l'Office européen des brevets à la date du
Les renseignements fournis sont donnés à titre indicatif et n'engagent pas la responsabilité de l'Office européen des brevets.

02-07-2001

| Document brevet cité au rapport de recherche | Date de publication | Membre(s) de la famille de brevet(s) | | Date de publication |
|---|---|---|---|---|
| DE 19736653 C | 10-12-1998 | AU | 9253498 A | 16-03-1999 |
| | | BR | 9811918 A | 15-08-2000 |
| | | CN | 1268268 T | 27-09-2000 |
| | | WO | 9911013 A | 04-03-1999 |
| | | EP | 1005735 A | 07-06-2000 |
| GB 2160392 A | 18-12-1985 | AUCUN | | |

EPO FORM P0460

Pour tout renseignement concernant cette annexe : voir Journal Officiel de l'Office européen des brevets, No.12/82